(19) Europäisches Patentamt
European Patent Office
Office européen des brevets

(11) EP 4 748 969 A1

(12) **EUROPEAN PATENT APPLICATION**
published in accordance with Art. 153(4) EPC

(43) Date of publication:
**27.05.2026 Bulletin 2026/22**

(21) Application number: **24856545.9**

(22) Date of filing: **23.08.2024**

(51) International Patent Classification (IPC):
***C23C 16/455*** (2006.01) ***C23C 16/16*** (2006.01)
***C23C 16/18*** (2006.01) ***C23C 16/448*** (2006.01)
***H01L 21/285*** (2006.01) ***H01L 21/3205*** (2006.01)
***H01L 21/768*** (2006.01) ***H01L 23/532*** (2006.01)
***H10D 64/60*** (2025.01)

(52) Cooperative Patent Classification (CPC):
**C23C 16/14; C23C 16/16; C23C 16/18; C23C 16/448; C23C 16/455; H10D 64/60; H10P 14/40; H10P 14/42; H10W 20/01; H10W 20/48**

(86) International application number:
**PCT/JP2024/030048**

(87) International publication number:
**WO 2025/041857 (27.02.2025 Gazette 2025/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.08.2023 JP 2023136531**

(71) Applicants:
- **Daikin Industries, Ltd.**
  **Osaka-shi, Osaka 530-0001 (JP)**
- **The University of Tokyo**
  **Bunkyo-ku, Tokyo 113-8654 (JP)**

(72) Inventors:
- **YAMAUCHI, Akiyoshi**
  **Osaka-Shi, Osaka 530-0001 (JP)**
- **KISHIKAWA, Yosuke**
  **Osaka-Shi, Osaka 530-0001 (JP)**
- **SAGISAKA, Shigehito**
  **Osaka-Shi, Osaka 530-0001 (JP)**
- **HAYASHI, Hisataka**
  **Osaka-Shi, Osaka 530-0001 (JP)**
- **NAKAMURA, Shingo**
  **Osaka-Shi, Osaka 530-0001 (JP)**
- **HORIGUCHI, Kazunori**
  **Osaka-Shi, Osaka 530-0001 (JP)**
- **SHIMOGAKI, Yukihiro**
  **Tokyo 113-8654 (JP)**
- **YAMAGUCHI, Jun**
  **Tokyo 113-8654 (JP)**
- **MOMOSE, Takeshi**
  **Tokyo 113-8654 (JP)**
- **SATO, Noboru**
  **Tokyo 113-8654 (JP)**

(74) Representative: **Hoffmann Eitle**
**Patent- und Rechtsanwälte PartmbB**
**Arabellastraße 30**
**81925 München (DE)**

(54) **METHOD FOR MANUFACTURING THIN FILM**

(57) A method for manufacturing a thin film, comprising:
a deposition process for depositing a raw material compound on a substrate material by atomic layer deposition using the raw material compound; and a film forming process for forming a thin film by reducing a deposited product with a reducing gas at a pressure of 4.5 Torr or more after the deposition process.



Processed by Luminess, 75001 PARIS (FR)

**(Cont. next page)**

[Fig. 1]

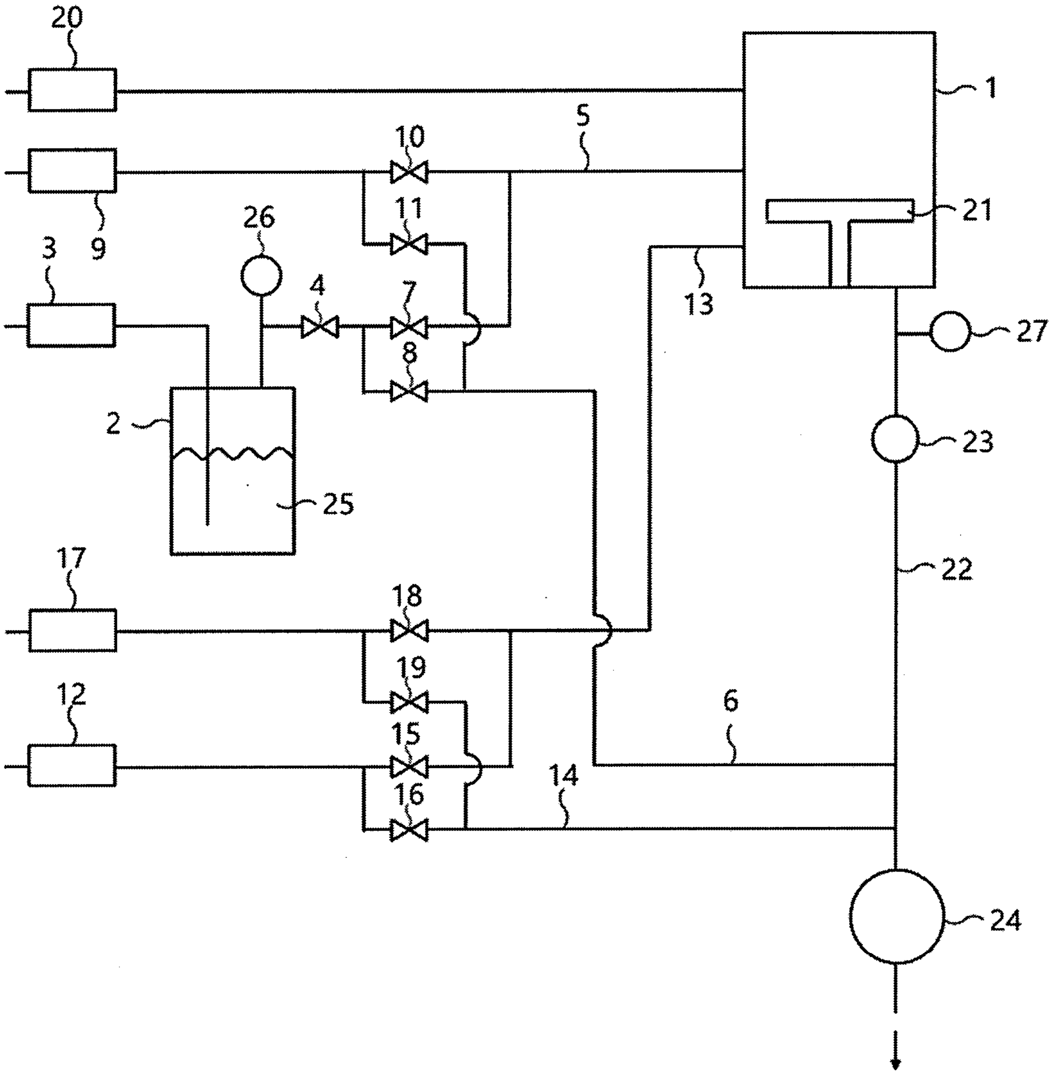

## Description

Technical Field

The present disclosure is related to a method for manufacturing a thin film.

Background Art

A method of manufacturing a thin film using atomic layer deposition (hereinafter also referred to as "ALD") has been known as a film forming method to various kinds of substrate materials.

Citation List

Patent Literature

Patent Literature 1: JP 2012-184449 A

Summary of Invention

Technical Problem

Conventionally, a thin film has been manufactured by using an ALD in which a reducing gas is used to perform a reducing gas process on a metal thin film formed on a substrate material. However, the obtained thin film contains some impurities, and resistivity of the thin film tends to be a high value.

The aim of the present disclosure is to provide a method for manufacturing a thin film having further reduced resistivity.

Solution to Problem

The present disclosure includes the following aspects.

[1] A method for manufacturing a thin film, including:
a deposition process for depositing a raw material compound on a substrate material by atomic layer deposition using the raw material compound; and a film forming process for forming a thin film by reducing a deposited product with a reducing gas at a pressure of 4.5 Torr or more after the deposition process.
[2] The method for manufacturing a thin film according to [1], wherein the pressure of the reducing gas is 7.8 Torr or more.
[3] The method for manufacturing a thin film according to [1] or [2], wherein the atomic layer deposition includes a vaporization process for vaporizing a raw material liquid containing the raw material compound before the deposition process.
[4] The method for manufacturing a thin film according to any one of [1] to [3], wherein the reducing gas is at least one selected from the group consisting of $H_2$, $NH_3$, hydrazine, monomethylhydrazine, dimethylhydrazine, formic acid, carboxylic acid compounds, formaldehyde, organic ammonia, silane compounds, diborane compounds, and alcohol compounds.
[5] The method for manufacturing a thin film according to any one of [1] to [4], wherein the raw material compound has a vapor pressure of 0.4 Torr or more at 100°C.
[6] The method for manufacturing a thin film according to any one of [1] to [5], wherein:

the raw material compound contains a metal atom; and
the metal atom is cobalt, ruthenium, tungsten, palladium, or molybdenum.

[7] The method for manufacturing a thin film according to any one of [1] to [6], wherein:

the raw material compound contains a metal atom and a ligand containing a coordinating element that coordinates to the metal atom; and
the coordinating element is at least one selected from C, N, O, and Si.

[8] The method for manufacturing a thin film according to any one of [1] to [7], wherein:

the raw material compound contains a ligand; and
the ligand contains at least one of a monodentate ligand and a polydentate ligand.

[9] The method for manufacturing a thin film according to [8], wherein:
the monodentate ligand is at least one selected from carbonyl, alkyne, alkyl, amine, aminoalkyl, and hydride.
[10] The method for manufacturing a thin film according to [8], wherein:

the polydentate ligand is a bidentate ligand; and
the bidentate ligand is at least one selected from alkyldiene, cyclopentadiene, and acetylacetonate.

[11] The method for manufacturing a thin film according to [8], wherein:

the polydentate ligand is a tridentate ligand; and
the tridentate ligand is amidinate.

[12] The method for manufacturing a thin film according to any one of [1] to [11], wherein:
the raw material compound is at least one selected from the following compounds:

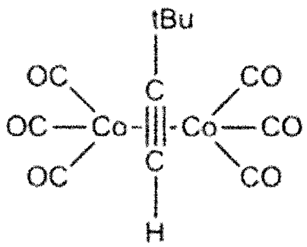
,
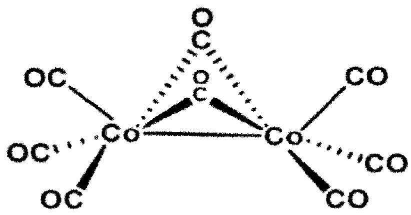
,
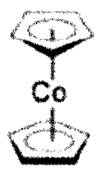
,
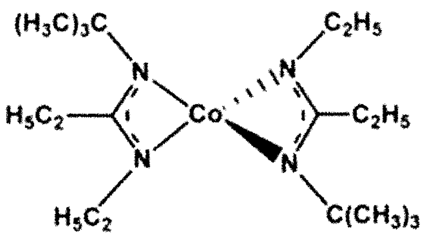
,
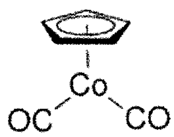

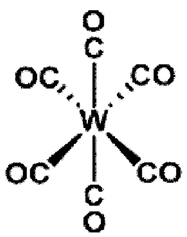
,
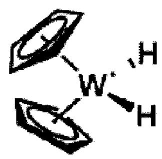
,
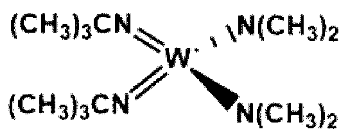
,

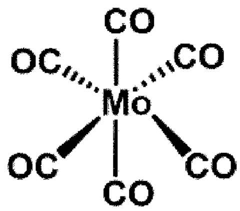

[13] The method for manufacturing a thin film according to [6] or [12], wherein a bulk resistivity $\rho_0$ of a cobalt thin film at room temperature in the following relational expression valid between resistivity and film thickness is 15 $\mu\Omega\cdot$cm or less:

$$\rho = \rho_0 + a/t$$

wherein p is a resistivity; $\rho_0$ is a bulk resistivity at room temperature; t is a film thickness (cm); and a is a constant.
[14] A thin film wherein a bulk resistivity $\rho_0$ of a cobalt thin film at room temperature in the following relational expression valid between resistivity and film thickness is 15 $\mu\Omega\cdot$cm or less:

$$\rho = \rho_0 + a/t$$

wherein p is a resistivity; $\rho_0$ is a bulk resistivity at room temperature; t is a film thickness (cm); and a is a constant.
[15] The thin film according to [14], wherein the content percentage of an impurity is 2.0 at.% or less.
[16] A stack containing the thin film according to [14] or [15].

Advantageous Effect of Invention

According to the manufacturing method of the present disclosure, a thin film having a low resistivity can be obtained.

Brief Description of Drawing

[Figure 1] Figure 1 is a schematic diagram illustrating an example of a film forming apparatus of the present disclosure.

Description of Embodiments

The present disclosure is described below. Unless specified otherwise, the invention according to the present disclosure is not limited to the descriptions below.

<Manufacturing method>

A method for manufacturing a thin film as one aspect of the present disclosure includes:

a deposition process for depositing a raw material compound on a substrate material by ALD using the raw material compound; and
a film forming process for forming a thin film by reducing a deposited product with a reducing gas at a pressure of 4.5 Torr or more after the deposition process.

In the method for manufacturing a thin film of the present disclosure, the pressure of the reducing gas is a high pressure of 4.5 Torr or more. Because of the high pressure, it is possible to reduce the content of an impurity contained in the formed thin film, and the resistivity of the thin film can be reduced. For example, a ligand contained in the thin film can be removed by using the reducing gas. The thin film having reduced resistivity can be used advantageously in, for example, a semiconductor application. The abovementioned impurity originates from the raw material compound and the like and contains, for example, carbon, oxygen, nitrogen and the like.
The pressure of the abovementioned reducing gas is 4.5 Torr or more, preferably 7.0 Torr or more, more preferably 7.8 Torr or more, for example, 8.0 Torr or more, specifically 8.3 Torr or more, more specifically 10 Torr or more. The upper limit of the pressure is not limited, but it is, for example, 15 Torr or less, preferably 12 Torr or less, for example, 10 Torr or less.

The ALD preferably includes a vaporization process for vaporizing a raw material liquid containing the raw material compound before the deposition process.

(Film forming apparatus)

A forming process for forming a thin film using the abovementioned ALD is usually performed by a film forming apparatus as indicated in Figure 1. In a film forming chamber 1, a deposition process for depositing a raw material compound that has been vaporized in a raw material container 2 is performed on a substrate prepared in advance, and the raw material compound is deposited on the substrate. Then, in the film forming chamber 1, a film forming process for forming a thin film by reducing the deposited product with a reducing gas is performed to form a thin film. In Figure 1, there is only one raw material container 2; however, for example, if two or more types of the raw material compounds are used, there may be two or more raw material containers. A film forming apparatus is described in detail below.

In the abovementioned raw material container 2, a raw material liquid 25 containing the raw material compound is heated as necessary to vaporize. The vaporized raw material compound is transported to the film forming chamber 1 by an inert carrier gas. The abovementioned raw material container 2 may be heated to, for example, 30°C or more, or it may be heated to 45°C or more, or it may be heated to 200°C or less, or it may be heated to 120°C or less, to vaporize the raw material liquid 25. The raw material liquid 25 may be heated to between 45°C and 120°C, or it may be heated to between 30°C and 200°C.

The abovementioned inert carrier gas is, for example, nitrogen, argon, helium, or the like. The flow rate of the inert carrier gas is adjusted by a mass flow controller (hereinafter also referred to as "MFC") 3. The pressure inside the raw material container 2 is adjusted by a needle valve 4. The flow rate of the inert carrier gas is, for example, 10 sccm to 100 sccm. The pressure inside the abovementioned raw material container 2 is measured by a pressure gauge 26, and a value of the pressure is, for example, 10 Torr to 100 Torr.

The abovementioned raw material container 2 is branched and connected to a supply line 5 connected to the film forming chamber 1 and an exhaust line 6. The supply line 5 and the exhaust line 6 have a valve 7 and a valve 8 respectively, and opening and closing of the valve 7 and the valve 8 switch between supplying and exhausting of the raw material. The abovementioned supply line 5 and the exhaust line 6 may have a heating mechanism. An example of the heating mechanism includes a heater placed around a pipe, typically a heating jacket.

The abovementioned supply line 5 and the exhaust line 6 can be purged by an inert purge gas. The inert purge gas is, for example, nitrogen, argon, helium, or the like. The flow rate of the inert purge gas is adjusted by MFC 9. The flow rate of the inert purge gas is, for example, 10 sccm to 100 sccm. Opening and closing of a valve 10 and a valve 11 switch between a purging destination to the supply line 5 or the exhaust line 6. A sequence is set so that if the raw material compound is flowing through the supply line 5, the inert purge gas flows through the exhaust line 6; and if the raw material compound is flowing through the exhaust line 6, the inert purge gas flows through the supply line 5.

If the reducing gas is a high-pressure gas, for example, hydrogen, it is supplied by adjusting its flow rate by MFC 12. The flow rate is, for example, 10 sccm to 1,000 sccm. If the reducing gas is liquid at normal temperature and pressure such as formic acid, it is supplied in the same way as the raw material compound by using an inert carrier gas.

A supply line for the reducing gas is branched to a supply line 13 connected to the film forming chamber 1 and an exhaust line 14. The supply line 13 and the exhaust line 14 have a valve 15 and a valve 16 respectively, and opening and closing of the valve 15 and the valve 16 switch between supplying and exhausting of the reducing gas. The abovementioned supply line 13 and the exhaust line 14 may have a heating mechanism. An example of the heating mechanism includes a heater placed around a pipe, typically a heating jacket.

The abovementioned supply line 13 and the exhaust line 14 can be purged by an inert purge gas. The inert purge gas is, for example, nitrogen, argon, helium, or the like. The flow rate of the inert purge gas is adjusted by MFC 17. The flow rate of the inert purge gas is, for example, 10 sccm to 100 sccm. Opening and closing of a valve 18 and a valve 19 switch between purging destinations to the supply line 13 or the exhaust line 14. A sequence is set so that if the reducing gas is flowing through the supply line 13, the inert purge gas flows through the exhaust line 14; and if the reducing gas is flowing through the exhaust line 14, the inert purge gas flows through the supply line 13.

A line may be connected to the abovementioned film forming chamber 1 for adjusting the flow rate of an inert balance gas. The inert balance gas is, for example, nitrogen, argon, helium, or the like. The flow rate of the inert balance gas is adjusted by MFC 20. The flow rate of the inert balance gas is, for example, 10 sccm to 100 sccm.

The abovementioned film forming chamber 1 is equipped with a substrate holder 21. Before the raw material compound is pulsed, the second principal surface of a substrate material as a film formation target usually comes into contact with the substrate holder 21. The second principal surface of the substrate material is a surface that is an opposite side of the first principal surface.

In the abovementioned film forming chamber 1, the raw material compound that has been vaporized in the raw material container 2 is pulsed. In other words, the vaporized raw material compound comes into contact with the first principal surface of the abovementioned substrate material, and a deposition process for depositing the raw material

compound on the substrate material is performed.

In the abovementioned film forming chamber 1, a film forming process for forming a thin film by reducing the deposited product with a reducing gas is performed after the deposition process.

The abovementioned film forming chamber 1 may be equipped with a heating mechanism and is heated to, for example, 100°C to 300°C.

The abovementioned film forming chamber 1 has a purging line 22 for purging a gas. The purging line 22 purges the residual raw material compound, the carrier gas, the reducing gas, and the like in the film forming chamber 1. Examples of a purging method include a method of purging the system with an inert gas, such as nitrogen or argon; a method of purging by reducing the pressure of the system; a method of combining these methods, and the like.

The abovementioned purging line 22 is equipped with a butterfly valve 23 for adjusting the pressure of the film forming chamber 1. The pressure of the film forming chamber 1 is adjusted by the opening degree of the butterfly valve 23. The pressure of the film forming chamber 1 is, for example, 10 Torr to 30 Torr.

The abovementioned purging line 22 is connected to the exhaust line 6 and the exhaust line 14 in the downstream of the butterfly valve 23 (in other words, in the opposite direction to the film forming chamber 1). The purging line 22 has a pump 24 in the downstream side of the connection points with the exhaust line 6 and the exhaust line 14.

As stated above, the raw material liquid 25 containing the raw material compound is present in the raw material container 2, and the raw material compound that has been vaporized in the raw material container 2 is transported to the film forming chamber 1 by the carrier gas through the supply line 5. In the film forming chamber 1, the raw material compound that has been vaporized in the raw material container 2 is deposited on a substrate that has been prepared in advance. Then, the deposited product is reduced by the reducing gas in the film forming chamber 1 to form a thin film. This process is repeated for the specified number of times to obtain a thin film having a desired film thickness.

(Raw material liquid 25)

The abovementioned raw material liquid 25 is a liquid containing the raw material compound. The raw material liquid 25 may contain an impurity.

Preferably, the abovementioned raw material liquid 25 is essentially made of the raw material compound. It should be noted that "essentially made of the raw material compound" means that the raw material liquid 25 may be made of the raw material compound only, or it may contain 2.0 at.% (atom%) or less of other compound, such as an impurity. The content of the impurity is a value that is measured by using an organic elemental microanalyzer, an inductively coupled plasma mass spectrometry (ICP-MS), or the like. Specifically, the weight of a metal element contained in the raw material compound is calculated by the elemental analysis, and the weight of an element other than the metal element contained in the raw material compound (main raw material component) is calculated. The weights of the metal element and the main raw material component obtained above are subtracted from the weight of the raw material compound to obtain a remaining weight, and a proportion of the abovementioned remaining weight against the raw material compound is taken as a proportion of the impurity.

Examples of the abovementioned impurity include a ligand of the raw material compound, such as carbon monoxide and organic compounds.

Only one type of the abovementioned raw material compound may be used, or two or more types may be used in combination.

The abovementioned raw material compound preferably contains a metal atom. Examples of the metal atom include a transition metal, specifically, cobalt, ruthenium, tungsten, palladium, or molybdenum. If such metal atom is used, it is possible to form a film of the metal atom with high purity. In addition, if such metal atom is used, it is possible to reduce the resistivity of the thin film. If the abovementioned metal atom is used to form a film on a wiring, wiring disconnection can be prevented.

Examples of the abovementioned metal atom include, more preferably, cobalt, tungsten, palladium, or molybdenum. If such metal atom is used, it is possible to especially reduce the resistivity of the thin film. In addition, if such metal atom is used to form a film on a wiring, wiring disconnection can be prevented.

Examples of the abovementioned metal atom include, more preferably, cobalt or tungsten. An example of the abovementioned metal atom includes, even more preferably, cobalt. If the abovementioned metal atom is used to form a film on a copper wiring, disconnection of copper wiring can be prevented.

The abovementioned metal atom may be, for example, cobalt or molybdenum. If the abovementioned metal atom is used to form a film on a copper wiring, disconnection of copper wiring can be prevented.

The abovementioned raw material compound preferably has a vapor pressure of 0.4 Torr or more, more preferably 1.0 Torr or more, at 100°C. For example, the raw material compound has a ligand, and decomposition of this ligand may form an impurity. By increasing the vapor pressure of the raw material compound, the amount of the impurity can be reduced.

The abovementioned raw material compound is preferably an organometallic compound. The organometallic

compound has a metal atom and a ligand coordinated to the metal atom.

The coordinating element that coordinates to the metal atom in the abovementioned ligand is preferably at least one selected from C, N, O, and Si.

Specifically, the abovementioned ligand contains at least one of a monodentate ligand and a polydentate ligand.

Examples of the abovementioned monodentate ligand include halogen, hydride, alkyne, alkyl, alkenyl, cycloalkyl, aryl, alkynyl, alkylimino, amine, aminoalkyl, dialkylaminoalkyl, monoalkylamino, dialkylamino, alkoxy, alkoxyalkyl, hydrazide, hydride, phosphide, nitrile, silyl, and carbonyl. Preferably, the monodentate ligand is at least one selected from carbonyl, alkyne, alkyl, amine, aminoalkyl, and hydride, and more preferably, the monodentate ligand is at least one selected from carbonyl and alkyne.

Examples of the abovementioned polydentate ligand include a bidentate ligand and a tridentate ligand.

Examples of the abovementioned bidentate ligand include diamine, di(silyl-alkyl)amino, di(alkylsilyl)amino, disilylamino, dialkylaminoalkoxy, alkyldiene, alkoxyalkyl dialkylamino, siloxy, diketonate, cyclopentadiene, cyclopentadienyl, pyrazolate, ketoiminate, diketiminato, and acetylacetonate. Preferably, the bidentate ligand is at least one selected from alkyldiene, cyclopentadiene, and acetylacetonate. In one aspect, the bidentate ligand is alkyldiene. In one aspect, the bidentate ligand is cyclopentadiene. In one aspect, the bidentate ligand is acetylacetonate.

Examples of the abovementioned tridentate or higher ligand include amidinate, guanidinate, phospho-guanidinate, and phospho-amidinate. Preferably, an example of the tridentate ligand includes amidinate.

The abovementioned ligand preferably contains at least one of a monodentate ligand, a bidentate ligand, and a tridentate ligand.

The abovementioned organometallic compound is preferably one selected from the following compounds. These organometallic compounds have a high vapor pressure, and so it is possible to perform ALD at a low temperature. By performing ALD at a low temperature, decomposition of the raw material compound can be prevented, and the content of an impurity originating from the raw material compound can be reduced.

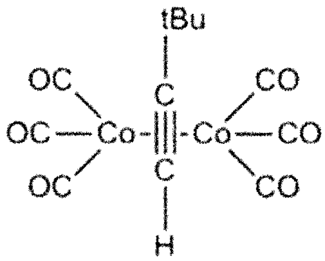 ,

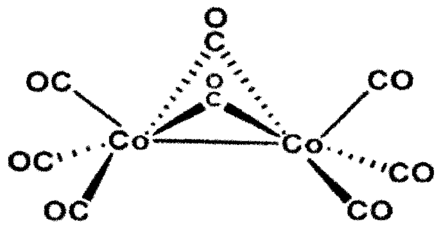 ,

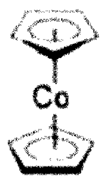 ,

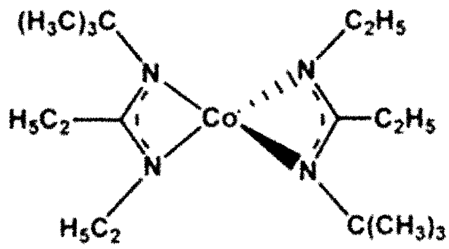 ,

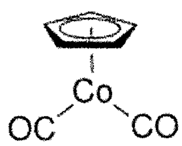

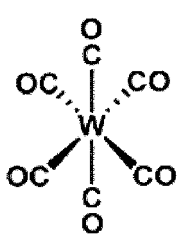 ,

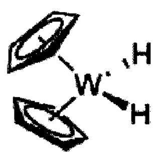 ,

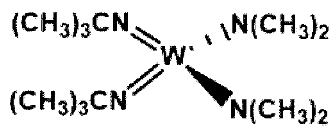 ,

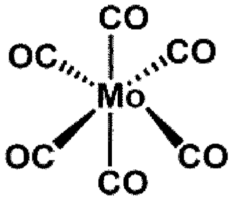

(Carrier gas)

An example of the abovementioned carrier gas includes an inert gas, such as nitrogen and a noble gas, and preferably, nitrogen or argon gas is used.

(Reducing gas)

The abovementioned reducing gas is not limited as long as it can react with the abovementioned raw material compound; however, examples include at least one selected from the group consisting of $H_2$, $NH_3$, hydrazine, monomethylhydrazine, dimethylhydrazine, formic acid, carboxylic acid compounds, formaldehyde, organic ammonia, silane compounds, diborane compounds, and alcohol compounds. The abovementioned reducing gas is preferably at least one selected from the group consisting of $H_2$ and dimethylhydrazine. By using such reducing gas, the decomposition of the reducing gas can be controlled; the formation of an impurity can be controlled; and contamination with the impurity on the formed thin film can be prevented. As a result, the resistivity of the thin film can be reduced. The content of the impurity contained on the thin film can be measured by using an X-ray photoelectron spectrometer, an organic elemental microanalyzer, an inductively coupled plasma mass spectrometry (ICP-MS), or the like, and preferably it can be measured by using the X-ray photoelectron spectrometer.

In one aspect, the abovementioned reducing gas is $NH_3$. By using such reducing gas, the decomposition of the reducing gas can be controlled; the formation of an impurity can be controlled; and contamination with the impurity on the formed thin film can be prevented. As a result, the resistivity of the thin film can be reduced. The content of the impurity can be measured by using the methods described above.

The abovementioned reducing gas may be one type of a gas, or multiple gases may be used in combination. If the reducing gas is a combination of multiple gases, the pressure of the reducing gas means a total value of the pressures of all the gases.

(Substrate material)

The abovementioned reducing gas reacts with the raw material compound that has been deposited on the substrate material and reduces the raw material compound. This forms a metal film (thin film) on the substrate material.

A material that composes the abovementioned substrate material is not limited, but examples include a metal such as copper, silver, gold, platinum, nickel, palladium, and aluminum; silicon; a ceramic material such as indium arsenide, indium gallium arsenide, silicon oxide, silicon nitride, silicon carbide, titanium nitride, tantalum oxide, tantalum nitride, titanium oxide, titanium nitride, ruthenium oxide, zirconium oxide, hafnium oxide, lanthanum oxide, and gallium nitride; and glass.

In one aspect, the material that composes the abovementioned substrate material is copper, silver, gold, platinum, nickel, palladium, or aluminum, and it is preferably copper.

A shape of the abovementioned substrate material is not limited, and it may be in the form of a plate, a rod, a sphere, a layer, a fiber, a flake, or the like.

In one aspect, the shape of the abovementioned substrate material may be in the form of a layer placed on a substrate, for example, a wiring on a wiring substrate.

The temperature of the substrate material when depositing the abovementioned raw material compound on the substrate material may be, for example, 20 to 600°C, preferably 50 to 500°C, more preferably 100 to 450°C, even more preferably 100 to 400°C.

The temperature of the substrate material when pulsing the abovementioned reducing gas to the film forming chamber 1 may be, for example, 20 to 600°C, preferably 50 to 500°C, more preferably 100 to 450°C, even more preferably 100 to 400°C. By performing in the abovementioned temperature range, the decomposition of the reducing gas can be controlled; the formation of an impurity can be controlled; and contamination with the impurity on the formed thin film can be prevented. As a result, the resistivity of the thin film can be reduced.

It should be noted that depending on the desired film thickness, the deposition process and the film forming process may be repeated; the deposition process may be repeated; or the film forming process may be repeated.

A bulk resistivity $\rho_0$ of a cobalt thin film at room temperature in the following relational expression between resistivity p and film thickness t is preferably 20 μΩ·cm or less, more preferably 15 μΩ·cm or less:

$$\rho = \rho_0 + a/t$$

wherein:

p is a resistivity;
$\rho_0$ is a bulk resistivity at room temperature;
t is a film thickness (cm); and
a is a constant.

The bulk resistivity $\rho_0$ is even more preferably 12 μΩ·cm or less, for example, 10 μΩ·cm or less. The lower limit of the bulk resistivity $\rho_0$ is not limited, but it is, for example, 9 μΩ·cm, preferably 7 μΩ·cm, more preferably 6 μΩ·cm. By preventing the contamination of the impurity as above, it is possible to form a thin film having reduced resistivity. It should be noted that the above expression is a relation that is generally valid between resistivity p and film thickness t in a cobalt thin film.

A bulk resistivity $\rho_0$ of a ruthenium thin film in the following relational expression between resistivity p and film thickness t is preferably 17 μΩ·cm or less:

$$\rho = \rho_0 + a/t$$

wherein:

p is a resistivity;
$\rho_0$ is a bulk resistivity at room temperature;
t is a film thickness (cm); and
a is a constant.

The bulk resistivity $\rho_0$ is more preferably 14 μΩ·cm or less, even more preferably 12 μΩ·cm or less. The lower limit of the bulk resistivity $\rho_0$ is not limited, but it is, for example, 10 μΩ·cm, preferably 8 μΩ·cm, more preferably 7.5 μΩ·cm. By preventing the contamination of the impurity as above, it is possible to form a thin film having reduced resistivity. It should be noted that the above expression is a relation that is generally valid between resistivity and film thickness in a ruthenium thin film.

A bulk resistivity $\rho_0$ of a tungsten thin film in the following relational expression between resistivity p and film thickness t is preferably 13 μΩ·cm or less:

$$\rho = \rho_0 + a/t$$

wherein:

p is a resistivity;
$\rho_0$ is a bulk resistivity at room temperature;
t is a film thickness (cm); and
a is a constant.

The bulk resistivity $\rho_0$ is more preferably 10 μΩ·cm or less, even more preferably 9 μΩ·cm or less. The lower limit of the bulk resistivity $\rho_0$ is not limited, but it is, for example, 8 μΩ·cm, preferably 6 μΩ·cm, more preferably 5 μΩ·cm. By preventing the contamination of the impurity as above, it is possible to form a thin film having reduced resistivity. It should be noted that the above expression is a relation that is generally valid between resistivity and film thickness in a tungsten thin film.

A bulk resistivity $\rho_0$ of a palladium thin film in the following relational expression between resistivity p and film thickness t is preferably 32 μΩ·cm or less:

$$\rho = \rho_0 + a/t$$

wherein:

p is a resistivity;
$\rho_0$ is a bulk resistivity at room temperature;
t is a film thickness (cm); and
a is a constant.

The bulk resistivity $\rho_0$ is more preferably 26 $\mu\Omega\cdot$cm or less, even more preferably 21 $\mu\Omega\cdot$cm or less. The lower limit of the bulk resistivity $\rho_0$ is not limited, but it is, for example, 19 $\mu\Omega\cdot$cm, preferably 15 $\mu\Omega\cdot$cm, more preferably 13 $\mu\Omega\cdot$cm. By preventing the contamination of the impurity as above, it is possible to form a thin film having reduced resistivity. It should be noted that the above expression is a relation that is generally valid between resistivity and film thickness in a palladium thin film.

A bulk resistivity $\rho_0$ of a molybdenum thin film in the following relational expression between resistivity p and film thickness t is preferably 12 $\mu\Omega\cdot$cm or less:

$$\rho = \rho_0 + a/t$$

wherein:

p is a resistivity;
$\rho_0$ is a bulk resistivity at room temperature;
t is a film thickness (cm); and
a is a constant.

The bulk resistivity $\rho_0$ is more preferably 10 $\mu\Omega\cdot$cm or less, even more preferably 8 $\mu\Omega\cdot$cm or less. The lower limit of the bulk resistivity $\rho_0$ is not limited, but it is, for example, 7 $\mu\Omega\cdot$cm, preferably 6 $\mu\Omega\cdot$cm, more preferably 5 $\mu\Omega\cdot$cm. By preventing the contamination of the impurity as above, it is possible to form a thin film having reduced resistivity. It should be noted that the above expression is a relation that is generally valid between resistivity and film thickness in a molybdenum thin film.

<Thin film>

In the present disclosure, a thin film is the one that is manufactured by the abovementioned manufacturing method. The thin film contains, for example, cobalt, ruthenium, tungsten, palladium, or molybdenum.

For the cobalt thin film according to one aspect of the present disclosure, a bulk resistivity $\rho_0$ in the following relational expression between resistivity p and film thickness t is preferably 20 $\mu\Omega\cdot$cm or less, more preferably 15 $\mu\Omega\cdot$cm or less:

$$\rho = \rho_0 + a/t$$

wherein:

p is a resistivity;
$\rho_0$ is a bulk resistivity at room temperature;
t is a film thickness (cm); and
a is a constant.

The abovementioned thin film is formed by the manufacturing method of the present disclosure, and as the amount of the impurity contained in the thin film is extremely small, it has the resistivity as above.

The thickness of the abovementioned thin film is preferably 10 nm to 30 nm, more preferably 10 nm to 20 nm, even more preferably 10 nm to 15 nm.

The abovementioned thin film is formed from a raw material compound. The raw material compound is as described above.

The content percentage of the impurity in the abovementioned thin film is preferably 2.0 at.% or less. The lower limit of the content percentage is not limited, but it is, for example, 0.01 at.% or more. The content of the impurity was measured in the same way as described above. The content of the impurity contained on the thin film is a value measured by using an X-ray photoelectron spectrometer, an organic elemental microanalyzer, an inductively coupled plasma mass spectrometry (ICP-MS), or the like, and preferably it is a value measured by using an X-ray photoelectron spectrometer.

< Stack >

A stack according to one aspect of the present disclosure contains a thin film formed by the abovementioned manufacturing method. An example includes the abovementioned cobalt thin film.

Having thus described the embodiments of the present disclosure, the present disclosure is not limited to these embodiments, and various modifications can be made.

[Examples]

The present disclosure is described with examples below, but the present disclosure is not limited to the following examples.

[Film forming process 1]

A film forming process was performed using the following methods:

1. The film forming chamber was vented to the atmosphere, and after placing the substrate on the substrate holder, the film forming chamber was evacuated.
2. Then, the temperatures inside the film forming chamber and the bubbler were set to 100°C and 45°C respectively, and the following conditions were set:

    $N_2$ flow rate: 10 sccm
    Flow rate of $N_2$ as CCTBA carrier: 10 sccm
    $H_2$ flow rate: 100 sccm
    Total pressure: 3 to 10 Torr, bubbler pressure: 3 to 10 Torr

3. A cycle of CCTBA supply (5 seconds), purging (3 seconds), $H_2$ supply (10 seconds), and purging (3 seconds) was set as one cycle. This cycle was repeated.

It should be noted that CCTBA is the following compound:

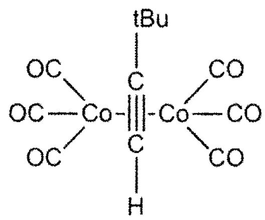

[Concentration measurement for metal element and impurity]

An X-ray photoelectron spectrometer (PHI-1600C manufactured by ULVAC-PHI, Inc.) was used to calculate the concentrations of a metal element and the impurity contained on the thin film.

(Example 1)

A film was formed according to the abovementioned film forming process. The pressure of the reducing gas $H_2$ for Example 1 was 8.3 Torr. The formed substrate material contained 98.8 at.% of Co and 1.2 at.% of carbon.

(Example 2)

A film was formed according to the abovementioned film forming process. The temperature of the substrate was 150°C, and the total pressure in the reactor was the value listed in Table 1. The pressure of the reducing gas $H_2$ for Example 2 was 6.0 Torr. The formed substrate material contained 98.0 at.% of Co and 2.0 at.% of carbon.

(Comparative Example 1)

A film was formed according to the abovementioned film forming process. The total pressure in the reactor was

the value listed in Table 1. The pressure of the reducing gas $H_2$ for Comparative Example 1 was 4.2 Torr.

The results are listed in Table 1.

[Table 1]

| Film forming conditions | Raw material metal | Substrate temperature [°C] | Reducing gas | Total pressure in the reactor [Torr] | $H_2$ pressure in the reactor [Torr] | Film forming speed [nm/cycle] | Resistivity [$\mu\Omega$ cm] | Co [at.%] | Carbon [at.%] |
|---|---|---|---|---|---|---|---|---|---|
| Example 1 | Co | 100 | $H_2$ | 10.0 | 8.3 | 0.02 | 10.1 | 98.8 | 1.2 |
| Example 2 | Co | 150 | $H_2$ | 6.6 | 6.0 | 0.01 | 15.5 | 98.0 | 2.0 |
| Comparative Example 1 | Co | 100 | $H_2$ | 5.0 | 4.2 | 0.02 | 33.0 | 95.0 | 5.0 |

The pressures of the reducing gas were 4.5 Torr or more in Examples 1 and 2 and less than 4.5 Torr in Comparative Example 1. The resistivities in Examples 1 and 2 were lower than the one in Comparative Example 1. Also, by increasing the pressure, the proportion of the impurity (carbon) contained on the obtained substrate was reduced.

[Film forming process 2]

Apart from using the following compound instead of CCTBA in the film forming process 1 and $NH_3$ as a reducing gas, a film forming process was performed in the same way as the film forming process 1:

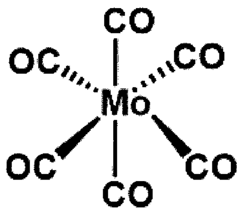

The concentrations of a metal element and the impurity were measured in the same way as above.

(Example 3)

A film was formed according to the abovementioned film forming process. The total pressure in the reactor was the value listed in Table 2.

(Comparative Example 2)

A film was formed according to the abovementioned film forming process. The total pressure in the reactor was the value listed in Table 2.

The results are listed in Table 2.

[Table 2]

| Film forming conditions | Raw material metal | Substrate temperature [°C] | Reducing gas | Total pressure in the reactor [Torr] | $NH_3$ pressure in the reactor [Torr] | Mo [at.%] | Carbon [at.%] | Oxygen [at.%] | Nitrogen [at.%] |
|---|---|---|---|---|---|---|---|---|---|
| Example 3 | Mo | 150 | $NH_3$ | 10 | 7.8 | 58.7 | 18.2 | 11.5 | 11.5 |
| Comparative Example 2 | Mo | 150 | $NH_3$ | 10 | 1.0 | 52.6 | 16.9 | 18.1 | 12.4 |

The pressures of the reducing gas were 4.5 Torr or more in Example 3 and less than 4.5 Torr in Comparative Example 2.

Industrial Applicability

According to the film forming method of the present disclosure, a thin film having a low resistivity can be formed efficiently, and therefore, the film forming method of the present disclosure can be used in various applications, for example, manufacturing of a circuit board and the like.

Reference Signs List

1: Film forming chamber
2: Raw material container
3, 9, 12, 17, 20: Mass flow controller
4: Needle valve
5, 13: Supply line
6, 14: Exhaust line
7, 8, 10, 11, 15, 16, 18, 19: Valve
21: Substrate holder
22: Purging line
23: Butterfly valve
24: Pump
25: Raw material liquid
26, 27: Pressure gauge

## Claims

**1.** A method for manufacturing a thin film, comprising:
a deposition process for depositing a raw material compound on a substrate material by atomic layer deposition using the raw material compound; and a film forming process for forming a thin film by reducing a deposited product with a reducing gas at a pressure of 4.5 Torr or more after the deposition process.

**2.** The method for manufacturing a thin film according to claim 1, wherein a pressure of the reducing gas is 7.8 Torr or more.

**3.** The method for manufacturing a thin film according to claim 1 or 2, wherein the atomic layer deposition comprises a vaporization process for vaporizing a raw material liquid containing the raw material compound before the deposition process.

**4.** The method for manufacturing a thin film according to any one of claims 1 to 3, wherein the reducing gas is at least one selected from the group consisting of $H_2$, $NH_3$, hydrazine, monomethylhydrazine, dimethylhydrazine, formic acid, carboxylic acid compounds, formaldehyde, organic ammonia, silane compounds, diborane compounds, and alcohol compounds.

**5.** The method for manufacturing a thin film according to any one of claims 1 to 4, wherein the raw material compound has a vapor pressure of 0.4 Torr or more at 100°C.

**6.** The method for manufacturing a thin film according to any one of claims 1 to 5, wherein the raw material compound comprises a metal atom, and the metal atom is cobalt, ruthenium, tungsten, palladium, or molybdenum.

**7.** The method for manufacturing a thin film according to any one of claims 1 to 6, wherein the raw material compound comprises a metal atom and a ligand comprising a coordinating element that coordinates to the metal atom, and wherein the coordinating element is at least one selected from C, N, O, and Si.

**8.** The method for manufacturing a thin film according to any one of claims 1 to 7, wherein:

the raw material compound comprises a ligand; and
the ligand comprises at least one of a monodentate ligand and a polydentate ligand.

**9.** The method for manufacturing a thin film according to claim 8, wherein:
the monodentate ligand is at least one selected from carbonyl, alkyne, alkyl, amine, aminoalkyl, and hydride.

**10.** The method for manufacturing a thin film according to claim 8, wherein:

the polydentate ligand is a bidentate ligand; and
the bidentate ligand is at least one selected from alkyldiene, cyclopentadiene, and acetylacetonate.

**11.** The method for manufacturing a thin film according to claim 8, wherein:

the polydentate ligand is a tridentate ligand; and
the tridentate ligand is amidinate.

**12.** The method for manufacturing a thin film according to any one of claims 1 to 11, wherein:
the raw material compound is at least one selected from the following compounds:

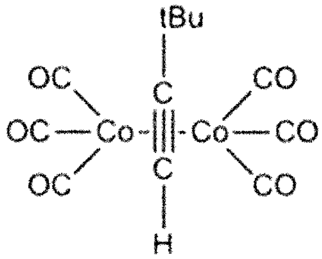
,
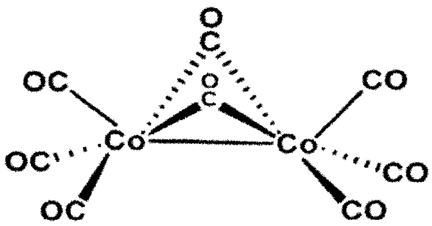
,

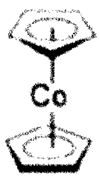
,
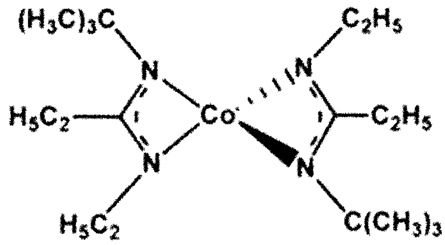
,

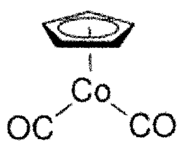

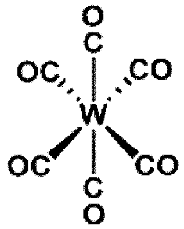
,
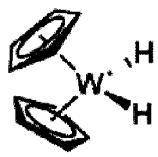
,
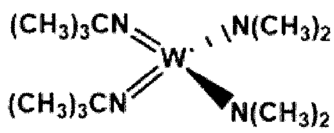
,

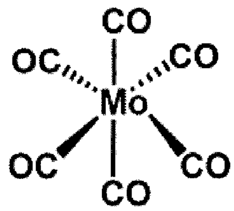

**13.** The method for manufacturing a thin film according to claim 6 or 12, wherein a bulk resistivity $\rho_0$ of a cobalt thin film at room temperature in the following relational expression valid between resistivity and film thickness is 15 $\mu\Omega\cdot$cm or less:

$$\rho = \rho_0 + a/t$$

wherein p is a resistivity; $\rho_0$ is a bulk resistivity at room temperature; t is a film thickness (cm); and a is a constant.

**14.** A thin film wherein a bulk resistivity $\rho_0$ of a cobalt thin film at room temperature in the following relational expression valid between resistivity and film thickness is 15 $\mu\Omega\cdot$cm or less:

$$\rho = \rho_0 + a/t$$

wherein p is a resistivity; $\rho_0$ is a bulk resistivity at room temperature; t is a film thickness (cm); and a is a constant.

**15.** The thin film according to claim 14, wherein the content percentage of an impurity is 2.0 at.% or less.

**16.** A stack comprising the thin film according to claim 14 or 15.

[Fig. 1]

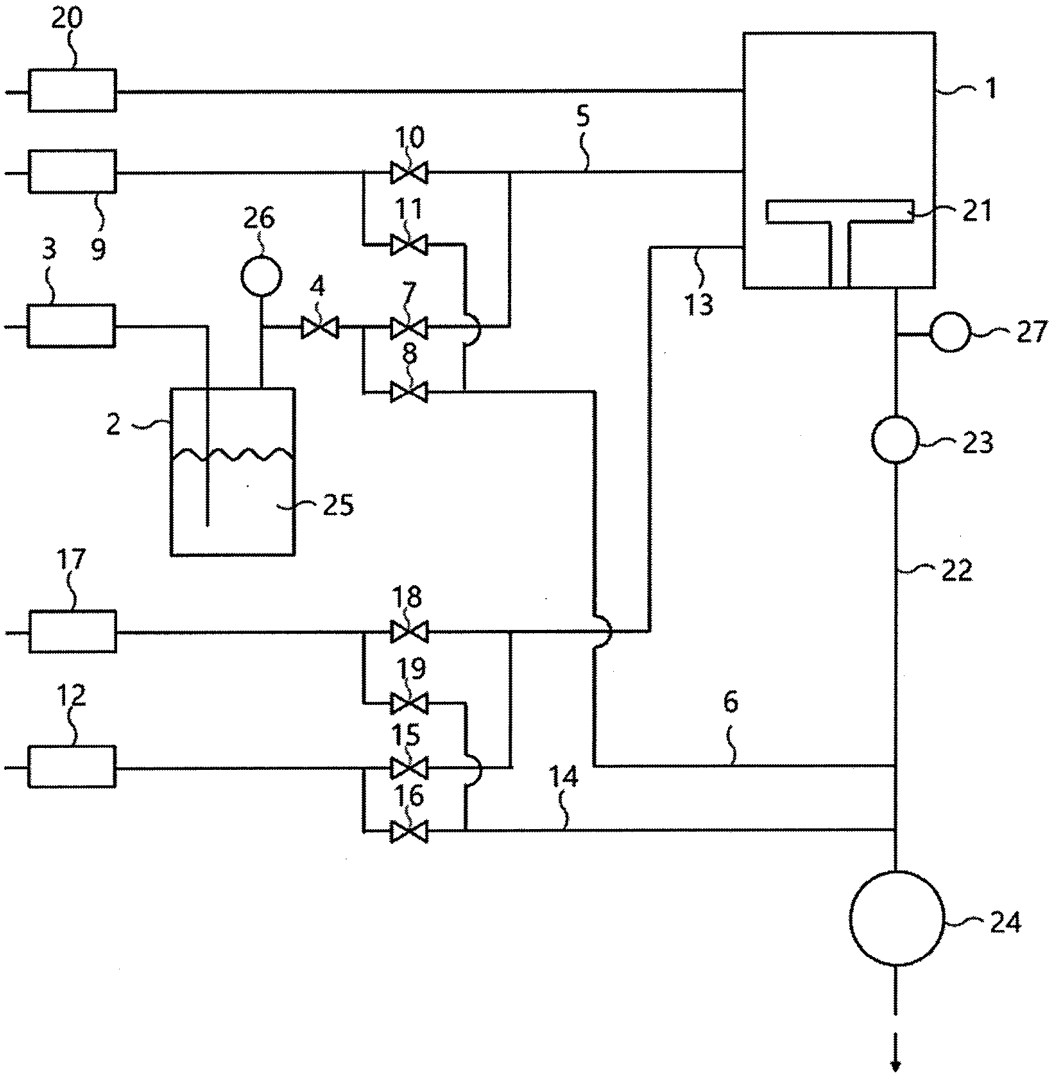

**INTERNATIONAL SEARCH REPORT**

International application No.
**PCT/JP2024/030048**

**A. CLASSIFICATION OF SUBJECT MATTER**

***C23C 16/455***(2006.01)i; ***C23C 16/16***(2006.01)i; ***C23C 16/18***(2006.01)i; ***C23C 16/448***(2006.01)i; ***H01L 21/285***(2006.01)i; ***H01L 21/3205***(2006.01)i; ***H01L 21/768***(2006.01)i; ***H01L 23/532***(2006.01)i; ***H10D 64/60***(2025.01)i
FI: C23C16/455; C23C16/448; H01L21/285 C; H01L21/28 301R; H01L21/88 M; H01L21/88 B; C23C16/18; C23C16/16

According to International Patent Classification (IPC) or to both national classification and IPC

**B. FIELDS SEARCHED**

Minimum documentation searched (classification system followed by classification symbols)

C23C16/455; C23C16/16; C23C16/18; C23C16/448; H01L21/28; H01L21/285; H01L21/3205; H01L21/768; H01L23/532

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2014-195066 A (HITACHI KOKUSAI ELECTRIC INC.) 09 October 2014 (2014-10-09) paragraphs [0077], [0107]-[0111], fig. 9-11 | 14-16 |
| Y | | 14-16 |
| A | | 1-13 |
| X | JP 2021-183723 A (ENTEGRIS, INC.) 02 December 2021 (2021-12-02) paragraphs [0042], [0049]-[0056] | 14-16 |
| Y | | 14-16 |
| A | | 1-13 |
| E, X | JP 2024-148230 A (KOJUNDO KAGAKU KENKYUSHO KK) 18 October 2024 (2024-10-18) paragraphs [0013]-[0036] | 1-8, 10, 13-16 |
| E, A | | 9, 11, 12 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 October 2024** | **12 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/030048**

**C. DOCUMENTS CONSIDERED TO BE RELEVANT**

| Category* | Citation of document, with indication, where appropriate, of the relevant passages | Relevant to claim No. |
|---|---|---|
| A | JP 2022-507300 A (ENTEGRIS, INC.) 18 January 2022 (2022-01-18)<br>entire text | 1-16 |
| A | JP 2023-527037 A (MERCK PATENT GMBH) 26 June 2023 (2023-06-26)<br>entire text | 1-16 |
| A | JP 2013-243382 A (AIR PRODUCTS AND CHEMICALS INC.) 05 December 2013 (2013-12-05)<br>entire text | 1-16 |
| A | JP 2022-023872 A (VERSUM MATERIALS US, LLC) 08 February 2022 (2022-02-08)<br>entire text | 1-16 |
| A | WO 2022/226010 A1 (APPLIED MATERIALS, INC.) 27 October 2022 (2022-10-27)<br>entire text | 1-16 |

Form PCT/ISA/210 (second sheet) (July 2022)

**INTERNATIONAL SEARCH REPORT**
**Information on patent family members**

International application No.
**PCT/JP2024/030048**

| Patent document cited in search report | Publication date (day/month/year) | Patent family member(s) | Publication date (day/month/year) |
|---|---|---|---|
| JP 2014-195066 A | 09 October 2014 | (Family: none) | |
| JP 2021-183723 A | 02 December 2021 | WO 2018/098061 A1<br>p. 9, lines 10-23, p. 11, line 8 to p. 13, line 13<br>US 2021/0082708 A1<br>US 2024/0096631 A1<br>US 2018/0158687 A1<br>TW 201829439 A<br>KR 10-2019-0071769 A<br>CN 109996803 A<br>JP 2020-513476 A | |
| JP 2024-148230 A | 18 October 2024 | (Family: none) | |
| JP 2022-507300 A | 18 January 2022 | US 2020/0157680 A1<br>entire text<br>WO 2020/101974 A1<br>KR 10-2021-0059791 A<br>CN 113039309 A<br>TW 202026302 A | |
| JP 2023-527037 A | 26 June 2023 | US 2023/0203645 A1<br>entire text<br>WO 2021/239596 A1<br>TW 202146688 A<br>CN 115667575 A<br>KR 10-2023-0015926 A | |
| JP 2013-243382 A | 05 December 2013 | US 2009/0130466 A1<br>entire text<br>EP 2060576 A1<br>CN 101469005 A<br>KR 10-2009-0050978 A<br>TW 200923119 A<br>KR 10-2012-0006966 A<br>JP 2009-132708 A | |
| JP 2022-023872 A | 08 February 2022 | US 2019/0382430 A1<br>entire text<br>EP 3584250 A1<br>KR 10-2019-0143395 A<br>CN 110615746 A<br>TW 202000685 A<br>JP 2019-218347 A | |
| WO 2022/226010 A1 | 27 October 2022 | US 2022/0356197 A1<br>US 2023/0382933 A1<br>EP 4326920 A1<br>CN 117178073 A<br>KR 10-2023-0171474 A<br>TW 202309060 A<br>JP 2024-514678 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2012184449 A